# EUROPEAN PATENT SPECIFICATION

(11) **EP 2 323 465 B1**
(45) Date of publication and mention of the grant of the patent: **20.02.2013**
(21) Application number: 10177982.5
(22) Date of filing: 21.09.2010
(51) Int. Cl.: H05K 1/02, H01L 23/36, H01L 23/40

(54) **Electrical circuit with heat sink**
Elektrischer Schaltkreis mit Kühlkörper
Circuit éléctrique avec dissipateur thermique

(30) Priority: 10.11.2009 IT TO20090861
(43) Date of publication of application: 18.05.2011
(73) Proprietor: OSRAM GmbH, 81543 München (DE); OSRAM S.P.A. - SOCIETA' RIUNITE OSRAM EDISON CLERICI, 20126 Milano (IT)
(72) Inventor: Piva, Raffaele, 31100 Treviso (IT)
(74) Representative: Bosotti, Luciano

(56) References cited:
- EP-A1- 2 043 412
- WO-A1-03/094586
- JP-A- 11 004 050
- JP-A- 2005 303 228
- US-A- 4 945 451
- US-A1- 2002 131 238
- US-A1- 2009 161 318

## Description

### Field of the invention

This disclosure relates to electrical circuits provided with heat sinks.

This disclosure was devised with specific attention paid to its possible application to electronic circuits mounted on printed circuit boards (PCBs).

### Description of the related art

The electrical/electronic components, particularly those components used in power applications, require an efficient heat dissipation in order to avoid reaching high temperatures, which may jeopardize correct operation.

A correct heat management of the circuit can actually improve its performance. For example, the "on" resistance of a MOSFET transistor is a direct function of to its operating temperature; higher temperatures lead to bigger losses in MOSFETs and to a consequent reduction of the overall efficiency of the electronic device.

So far this problem has been dealt with in various ways, e.g.:
- by creating on the printed circuit board or PCB, in the mounting sites of the components (for example surface mounted devices or SMDs), wide copper areas, so as to improve heat dissipation by using the copper area as a heat sink;
- by arranging, in the case of SMDs mounted on the bottom side of the PCB, thermal pads between the SMD components and the bottom of the device housing, so as to use the housing itself as a heat sink;
- by embedding the whole device into materials such as resins, potting masses, asphalt etc., so as to increase the heat dissipation effect of the power components.

More specifically, the invention relates to an electrical circuit having the features of the preamble of claim 1, which is known, e.g. from US 4 945 451 A. A somewhat similar arrangement is known, e.g. from JP 11 004050 A. Other documents of some interest for the invention include e.g. US 2009/161318 A1, EP 2 043 412 A1, WO 03/094586 A1, US 2002/131238 A1 and JP 2005 303228A.

### Object and summary of the invention

The previously mentioned solutions cannot be considered as completely satisfactory, especially in the case of SMD components.

The object of the invention is to provide a solution that represents an improvement over the previous solutions, both as regards the dissipating efficiency and as regards the need of an easy and efficient assembly procedure of heat sinks within production lines.

According to the invention, such an object is achieved thanks to a circuit having the features specifically set forth in the claims that follow.

The claims are an integral part of the technical teaching of the invention provided herein.

### Brief description of the annexed representations

The invention will now be described, by way of example only, with reference to the enclosed representations, wherein:

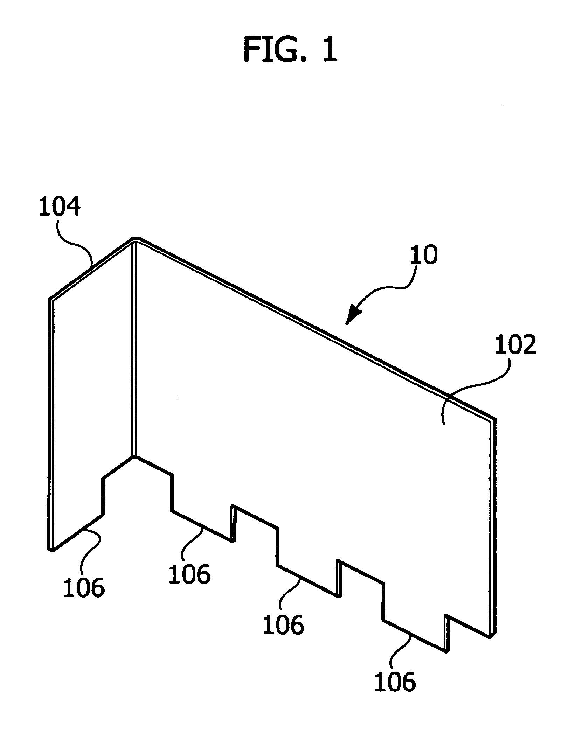

- Figure 1 is an overall perspective view of a heat sink,
- Figure 2 shows said heat sink mounted on a printed circuit board (PCB),
- Figure 3 shows an embodiment of a heat sink, and
- Figure 4 substantially corresponds to a section through line IV-IV in Figure 3.

### Detailed description of embodiments

In the following description, numerous specific details are given to provide a thorough understanding of embodiments. The embodiments can be practiced without one or more of the specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

In the Figures of the annexed drawings, reference 10 denotes on the whole a heat sink that can be associated with an electrical/electronic circuit, comprising components C, such as SMD (surface mounted device) components, mounted on a printed circuit board (PCB) 12, which in the present case is assumed to be a flat structure of any size or shape.

In the current printed circuit technology, on board 12 there are formed conductive metal tracks or strips, adapted to make up the electrical input/output connections of components C.

By way of example only (without being limitative to the invention), components C may be transistors such as, for example, MOSFET power transistors. In the Figures therefore there is shown, always by way of example, an electrically conductive line 14, obtained by known means on the printed circuit board 12 and defining an electrically conductive line of the output current of said transistors C.

In the presently considered example, the electrically conductive line (or strip, track or metal stripe, according to the rather rich vocabulary used in the printed circuit technology) 14 has a general S-shape, and therefore comprises:
- a substantially straight end section, denoted by 140, extending in the vicinity of components C (in this case the presence has been assumed of three components C in line with one another),
- an intermediate section 142, and
- a further straight end section 144, extending within a further general circuit block D, which may contain for example a transformer.

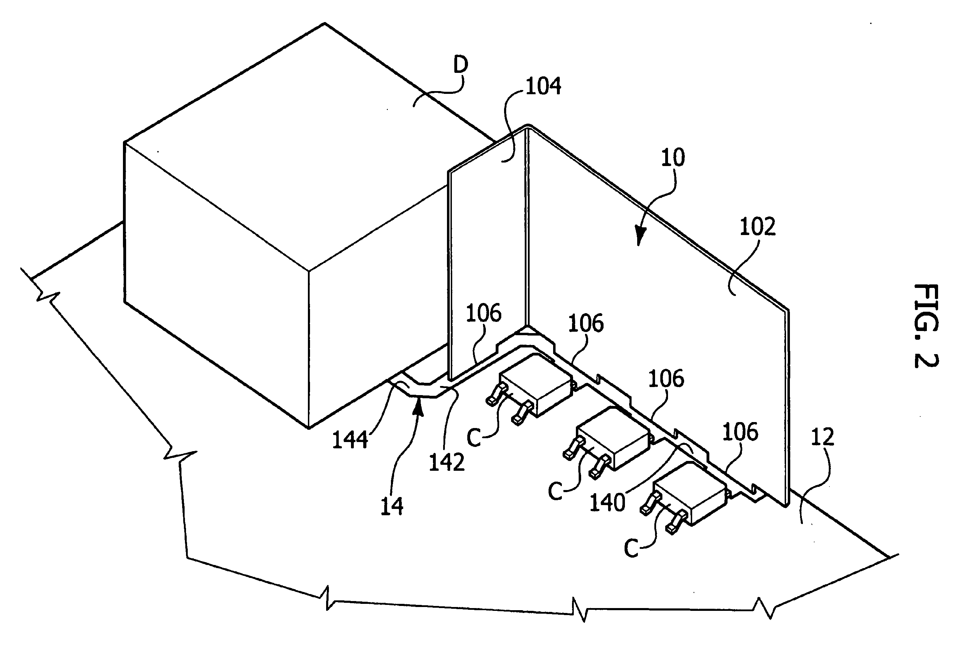

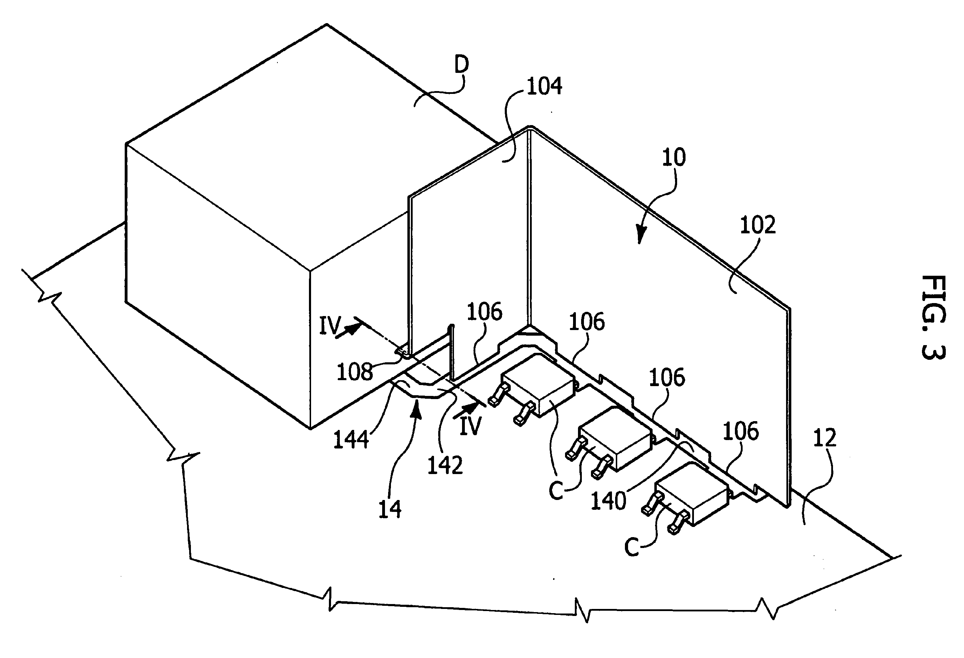

The annexed Figures, particularly Figures 2 and 3, are deliberately schematic because, generally speaking, on the board 12 there will also be arranged other connections, such as the conductive line 14.

The presently considered conductive line 14 represents therefore an example of a connection that must perform a heat dissipating function, for example because the conductive line 14 is associated with power circuits producing heat during their operation.

The heat sink 10 performs such heat dissipating function, with the further possibility of performing electrical conduction as well, being composed of an electrically conductive material.

The heat sink 10 therefore cooperates with the conductive line 14 (or, in various embodiments, at least partly replaces it) in performing a function of electrical connection of circuits C.

In various embodiments, the heat sink 10 has the form of a sheet-like body, extending transversely (in practice orthogonally or substantially orthogonally) with respect to the plane of the board 12.

Specifically, in the annexed Figures, board 12 is shown as extending on a substantially horizontal plane: the heat sink 10 constitutes a shaped sheet-like body protruding upwards, and therefore vertically, orthogonal with respect to the horizontal position of the board 12. The reference to an orthogonal extension must be understood as a relative orientation: for example, in the case that the board 12 extends on a vertical plane, the heat sink 10 will extend on the whole in the horizontal direction.

As can be seen in the various views, the heat sink 10 is a shaped sheet-like body with a shape which reproduces, where it is present, the shape of connection 14.

In the presently considered example (which is to be construed as exemplary only), the connection 14 has the shape of an S, with three branches 140 (first end branch), 142 (middle branch) and 144 (second end branch).

The heat sink 10 has a general L shape, with a first branch 102, coextensive with the branch 140 of connection 14, and a second branch 104, coextensive with the middle section 142 of connection 14.

The heat sink 10 can therefore have pin formations 106 extending towards connection 14, with the possibility to obtain an electrical connection with the latter.

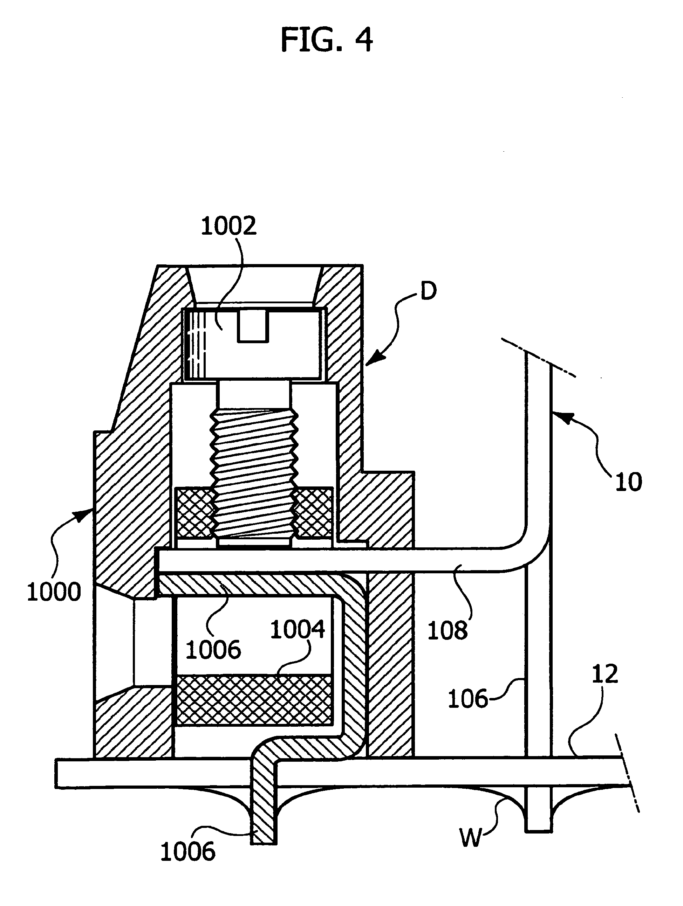

The pins 106 may extend through corresponding slots provided both in the connection 14 and in the board 12, so as to carry out a soldered connection (for example making use of the wave soldering technology) as schematically depicted at W in Figure 4.

The Figures in the annexed drawings refer to embodiments wherein the heat sink 10 is electrically connected with the conductive line 14 and therefore, beside performing the pertaining heat dissipating function, it also cooperates with the conductive line 14 in order to obtain an electrical connection path (with a wide section and therefore low ohmic resistance).

In various embodiments, it is however possible to obtain both the heat dissipating function and the electrical connection by using the heat sink 10, by avoiding the formation of the conductive line 14 in the areas where the latter would be coextensive with the heat sink 10. Referring to the examples shown in the Figures, in these embodiments the branch 140 and most of the branch 142 of the conductive line 14 would be omitted, while making use, for the electrical connection of the circuits C, of the branch 102 and the branch 104 of the heat sink 10.

The heat sink 10 can therefore be formed of a material having both heat conductive and electrically conductive properties. A possible choice of a material may consist in phosphor bronze, which beside having the previously mentioned properties offers the further advantage of a low cost. Moreover, it additionally shows excellent soldering ability with the conductive line 14 (where it is present), which is normally made of a copper-based material.

Heat dissipation naturally increases if the heat sink surface increases, and as the heat sink 10 extends in an orthogonal direction with respect to the board 12, there is a possibility to raise the size of the heat sink 10, by extending it in the orthogonal direction with respect to the board 12, without interfering with the board features and with the mounting of the components C on the latter, in particular when the SMD technology is used.

As it is possible to replace, at least partly, the conductive line 14 by using the heat sink 10 as an electrically conductive line as well, the conductive line 14 shown in the drawings can actually be considered as representing an electrical connection path of the circuits C, which connection path can be obtained:
- through the combination of the conductive line 14 (as a physical element of conductive material) provided on the board 12 and of the heat sink 10, which itself performs electrical conduction functions, or
- through the heat sink 10 only, where it is present.

The various embodiments are characterized by the possibility of optimizing the manufacturing process by simplifying assembly operations (for example the possibility of fixing the heat sink 10 to the board 12 by using the wave soldering method, W in Figure 4). This does not require particular dedicated housings (for example with potting masses or thermal pads). Moreover, the opportunity is provided to combine the presently described heat dissipation system with existing systems, so as to improve the thermal/electrical behavior of components C (specifically of the SMD power components) while increasing the efficiency of the electronic system as a whole.

Figures 3 and 4 show a further connection option of the heat sink 10, adapted to be used in addition or in alternative to what previously described.

In the embodiments of Figures 3 and 4, the branch 104 of the heat sink has a tab formation 108 that protrudes in the horizontal direction from branch 104 towards the outside of the L-shaped path of the heat sink 10, and penetrates within the housing of the device D, where it is fixed by a clamp 1000. The latter clamp is provided with a fixing screw 1002, which is adapted to move vertically an equipment 1004, adapted to perform a clamping action on a pin 1006, which is fixed (once again by wave soldering, for example) to the board 12.

In various embodiments, the structure of such a clamp may be as described in EP-A-1 096 606.

In the specific case, the tab 108 penetrates within the housing of the clamp 1000 while directly overlaying the head section, denoted by 1006a, of pin 1006. Tab 108 can therefore be subjected to the clamping action exerted by the screw 1002.

Of course, without prejudice to the underlying principles of the invention, the details and the embodiments may vary, even appreciably, with respect to what has been described by way of example only, without departing from the scope of the invention as defined by the claims that follow.

## Claims

1. An electrical circuit including:
- a printed circuit board (12) for mounting circuit components (C) with an electrically conductive line (14) extending over a given connection path over said printed circuit board (12), and
- a heat sink element (10) of an electrically conductive material to dissipate heat produced by said components (C), wherein said heat sink element (10) is comprised of a shaped sheet-like body extending orthogonal to said printed circuit board (12), wherein said heat sink element (10) is provided with pin formations (106) for connection to said printed circuit board (12), and wherein said heat sink element (10) has a L shape with a first branch (102) and a second branch (104),
**characterized in that**:
- said heat sink element (10) is provided with pin formations (106) for connection to said printed circuit board (12) in both said first branch (102) and said second branch (104),
- said heat sink element (10) with said L shape performs electrical conduction functions over at least part (140, 142) of the electrically conductive line (14) extending over said given connection path, and
- said heat sink element (10) has a protruding tongue (106) co-operating with a clamp (1000) fixed (1006) onto said printed circuit board (12) to fix the heat sink element (10) onto said printed circuit board (12).

2. The circuit of claim 1, including an electrically conductive element (14) on said printed circuit board (12) extending over said given connection path with said heat sink element (10) coupled to said electrically conductive element (14).

3. The circuit of claim 1, wherein said heat sink element (10) is connected by means of said pin formations (106) to said printed circuit board (12) via wave soldering (W).

4. The circuit of claim 1 and claim 2, wherein said pin formations (106) also provide connection with said electrically conductive element (14).

5. The circuit of claim 1, wherein said clamp is a screw (1002) clamp.

6. The circuit of any of the previous claims, wherein said heat sink element (10) is comprised of phosphorous bronze.

## Patentansprüche

1. Elektrische Schaltung, aufweisend:
eine gedruckte Leiterplatte (12) zum Befestigen von Schaltungskomponenten (C) mit einer elektrisch leitenden Leitung (14), die sich über einen gegebenen Verbindungsweg über die gedruckte Leiterplatte (12) erstreckt, und
ein Kühlkörperbauteil (10) aus einem elektrisch leitenden Material zum Verteilen von Hitze, die durch die Komponenten (C) erzeugt wird, wobei das Kühlkörperbauteil (10) umfasst ist von einem geformten blattartigen Körper, der sich orthogonal zu der gedruckten Leiterplatte (12) erstreckt, wobei das Kühlkörperbauteil (10) bereitgestellt wird mit Stiftausbildungen (106) zum Verbinden mit der gedruckten Leiterplatte (12), und wobei das Kühlkörperbauteil (10) eine L-Form mit einem ersten Arm (102) und einem zweiten Arm (104) aufweist,
**dadurch gekennzeichnet, dass**:
das Kühlkörperbauteil (10) mit Stiftausbildungen (106) zum Verbinden mit der gedruckten Leiterplatte (12) in sowohl dem ersten Arm (102) als auch dem zweiten Arm (104) bereitgestellt wird,
das Kühlkörperbauteil (10) mit der L-Form elektrische Leitungsfunktionen über zumindest einen Teil (140,142) der elektrisch leitenden Leitung (14) ausführt, die sich über einen gegebenen Verbindungsweg erstreckt, und
das Kühlkörperbauteil (10) eine vorstehende Zunge (106), die mit einer Klemme (1000) zusammenwirkt (1006), die auf der gedruckten Leiterplatte (12) befestigt wird, um das Kühlkörperbauteil (10) auf der gedruckten Leiterplatte (12) zu befestigen.

2. Schaltung nach Anspruch 1, die ein elektrisch leitendes Bauteil (14) auf der gedruckten Leiterplatte (12) umfasst, die sich über den gegebenen Verbindungsweg mit dem Kühlkörperbauteil (10) erstreckt, das mit dem elektrisch leitenden Bauteil (14) gekoppelt wird.

3. Schaltung nach Anspruch 1, wobei das Kühlkörperbauteil (10) durch Mittel der Stiftausbildungen (106) mit der gedruckten Leiterplatte (12) über Schwall-Löten (W) verbunden wird.

4. Schaltung nach Anspruch 1 und Anspruch 2, wobei die Stiftausbildungen (106) auch eine Verbindung mit dem elektrisch leitenden Bauteil (14) bereitstellen.

5. Schaltung noch Anspruch 1, wobei die Klemme eine Schrauben (1002) -Klemme ist.

6. Schaltung nach irgendeinem der vorhergehenden Ansprüche, wobei das Kühlkörperbauteil (10) umfasst ist aus phosphorhaltiger Bronze.

## Revendications

1. Un circuit électrique comprenant :
- une carte de circuit imprimé (12) pour monter des composants de circuit (C) avec une ligne électriquement conductrice (14) s'étendant au-dessus d'un chemin de connexion donné au-dessus de ladite carte de circuit imprimé (12), et
- un élément de drain thermique (10) d'un matériau électriquement conducteur pour dissiper la chaleur produite par lesdits composants (C), ledit élément de drain thermique (10) étant formé d'un corps en feuille conformé s'étendant perpendiculairement à ladite carte de circuit imprimé (12), ledit élément de drain thermique (10) étant pourvu de formations en broche (106) pour liaison à ladite carte de circuit imprimé (12), et ledit élément de drain thermique (10) présentant une forme en L avec une première branche (102) et une seconde branche (104),
**caractérisé en ce que** :
- ledit élément de drain thermique (10) est pourvu de formations en broche (106) pour liaison à ladite carte de circuit imprimé (12) à la fois dans ladite première broche (102) et ladite seconde broche (104),
- ledit élément de drain thermique (10) avec ladite forme en L assure des fonctions de conduction électrique sur au moins une partie (140, 142) de la ligne électriquement conductrice (14) s'étendant au-dessus dudit trajet de liaison donné, et
- ledit élément de drain thermique (10) présente une languette saillante (106) coopérant avec une pince (1000) fixée (1006) sur ladite carte de circuit imprimé (12) pour fixer l'élément de drain thermique (10) sur ladite carte de circuit imprimé (12).

2. Le circuit de la revendication 1, comprenant un élément électriquement conducteur (14) sur ladite carte de circuit imprimé (12) s'étendant au-dessus dudit trajet de liaison donné avec ledit élément de drain thermique (10) couplé audit élément électriquement conducteur (14).

3. Le circuit de la revendication 1, dans lequel ledit élément de drain thermique (10) est relié au moyen desdites formations en broche (106) à ladite carte de circuit imprimé (12) via une brasure à la vague (W).

4. Le circuit de la revendication 1 et de la revendication 2, dans lequel lesdites formations en broche (106) assurent également une liaison avec ledit élément électriquement conducteur (14).

5. Le circuit de la revendication 1, dans lequel ladite pince est une pince à vis (1002).

6. Le circuit de l'une des revendications précédentes, dans lequel ledit élément de drain thermique (10) est réalisé en bronze phosphoreux.
